# EUROPEAN PATENT SPECIFICATION

(11) **EP 0 917 185 B1**
(45) Date of publication and mention of the grant of the patent: **07.01.2009**
(21) Application number: 97830603.3
(22) Date of filing: 14.11.1997
(51) Int. Cl.: H01L 21/3205, H01L 21/28

(54) **Deposition process of in-situ doped polysilicon layers**
Verfahren zur Abscheidung von in-situ dotierten Polysilizium-Schichten
Méthode de déposition de couches de polysilicium dopées in-situ

(43) Date of publication of application: 19.05.1999
(73) Proprietor: STMicroelectronics S.r.l., 20041 Agrate Brianza (Milano) (IT)
(72) Inventor: Zambrano, Raffaele, 95029 Viagrande (CT) (IT)
(74) Representative: Viering, Jentschura & Partner

(56) References cited:
- EP-A- 0 467 190
- EP-A- 0 491 976
- EP-A- 0 772 231
- GB-A- 2 251 123
- US-A- 4 663 645
- US-A- 4 977 104

## Description

This invention concerns an *in-situ* deposition and doping process of one or more polycrystalline silicon layers for semiconductor electronic devices.

Polycrystalline silicon, also called polysilicon or polySi, as referred to in the following, is an essential material used in MOS technologies, generally in integrated circuit technologies for its possibility of being doped at such levels making it a substantially degenerate semiconductor, or having a metal type behaviour in respect to electric conduction PolySi is usually grown starting from SiO₂ layers, whereby the material achieved is formed by crystals whose size is smaller than a micrometer, also called grains

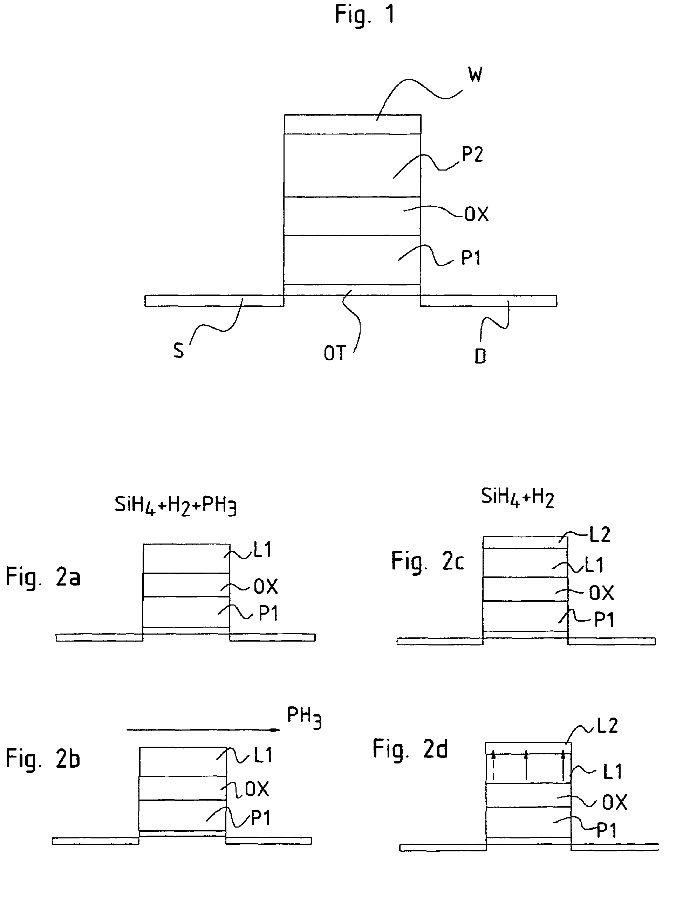

One of polySi applications, for instance, is to be found in the structures of memory devices, the socalled Flash devices. The structure of such a device is shown in Fig 1 during an intermediate process stage following gate stack definition, i.e. the whole of layers forming the gate, before reoxidation process

The gate stack consists of a first layer P1 of polySi type n⁻, ie consistently doped (eg. 10²⁰ atoms/cm³), deposited over a thin layer of tunnel oxide OT, by a dielectric produced by a sequence of oxide layers OX consisting of SiO_{2.}SiN₄ and SiO₂ again, called ONO, deposited on polySi layer P1, and of a second polySi layer P2, also type n⁻, on which a silicide layer W (WSi_{2.}TiSi₂ or others) is deposited, as required to reduce series resistance of the gate.

Source S and drain D areas of the memory cell are located on the stack sides. Both these two S and D areas are diffused simultaneously during the subsequent reoxidation process, where also the growth of a thin SiO₂ layer on the stack sides is provided

As to the polySi gate layer, the trend is to use more and more the *in-situ* doping technique, through which both the layer growth and its doping (usually obtained with the use of phosphorous introduced directly in the growth mixture, eg. in the form of phosphine, PH₃) occur at the same time

The reasons for *in-situ* doping are due to the fact that liquid phase doping from POCl₃ is less and less used being intrinsically "dirty", i.e many spurious particles are generated with the result of a highly defective polySi layer. On the contrary, the ionic implantation technique will not reach the same high doping values and requires an extensive use of implantation machines with the result of a much finer layer grain, not always desirable, specifically for the use in volatile memory devices

The problems related to *in-situ* polySi doping derive essentially from the high doping level to be reached and considerable grain size.

As a matter of fact, the segregation phenomenon occurring along the grain edges, i.e. the phenomenon where the dopant atoms tend to locate over the microcrystal external surface exploiting the unsaturated bonds, may cause excessive localized accumulations of dopant and even a of the layer itself, i e. some grains coming off the layer and causing a defective state

Another drawback derives from the phenomenon known as 'out-doping' occurring during the reoxidation thermal treatment, i.e. due to the high process temperature, the polySi deposited also on the wafer slice backside will release some dopant and contaminate the oxidating gaseous atmosphere, extending to the front open areas. As a result, doping of both the active and insulating areas of the device may be considerably altered.

A likely solution for the above drawback is using a reoxidation process characterized by deposition of an oxide layer over the doped polySi since its first growth stage, to provide a barrier to P atoms diffusion. Unfortunately, this technique has other drawbacks, such as an increase of crystallographic defects, since the growth of an oxide layer takes place before carrying out an 'annealing' treatment of the defects generated during the implantation stage and a reduced adhesion of the silicide layer to the underlaying polySi.

Another solution provides for removal of a part of doped polySi from the wafer slice backside before reoxidation However, this technique will increase process costs and generate further defects.

Therefore, it is the object of this invention to solve the above drawbacks and provide a more efficient and improved *in-situ* deposition and doping process of one or more polycrystalline silicon layers

In order to manufacture gate conductors for field effect semiconductor devices, it is known from EP0772231 to deposit two consecutive layers of polysilicon. The process according to EP0772231 presents some disadvantages, mainly due to the fact that out-doping effect is not completely prevented.

To this purpose, it is the main object of this invention to provide an *in-situ* deposition and doping process of one or more polycrystalline silicon layers to prevent the dopant from reaching the surface during the subsequent thermal treatments.

A further object of this invention is to provide an *in-situ* deposition and doping process of one or more polycrystalline silicon layers to prevent introduction of additional defectivity.

A further object of this invention is to provide an *in-situ* deposition and doping process of one or more polycrystalline silicon layers to ensure a good adhesion degree of the silicide layers over polycrystalline silicon.

A further object of this invention is to provide an *in-situ* deposition and doping process of one or more polycrystalline silicon layers to prevent subsequent removal of a part of the polycrystalline silicon that has been deposited.

To reach said purposes it is the object of this invention to provide an *in-situ* deposition and doping process of one or more polycrystalline silicon layers, as claimed in claim 1.

Further objects, characteristics and benefits of this invention will become apparent from the following detailed description and annexed drawings, which are only supplied by way of non limiting example, wherein:
- Fig. 1 shows schematically in main line the structure of a flash memory device according to the known state of art, during an intermediate process stage;
- Fig. 2a shows schematically in main line a first step of the *in-situ* deposition and doping process of one or more layers of polycrystalline silicon according to this invention;
- Fig. 2b shows schematically in main line a second step of the *in-situ* deposition and doping process of one or more layers of polycrystalline silicon according to this invention;
- Fig. 2c shows schematically in main line a third step of the *in-situ* deposition and doping process of one or more layers of polycrystalline silicon according to this invention;
- Fig. 2d shows schematically in main line a fourth step of the *in-situ* deposition and doping process of one or more layers of polycrystalline silicon according to this invention.

As seen, Fig. 2a shows a first step of the *in-situ* deposition and doping process of a polySi layer, corresponding to the layer P2 of the Flash memory device 1 represented in Fig. 1, i.e. on which the silicide layer W will then be deposited. A first intermediate polySi layer L1 of the device shown in Fig. 1 is deposited during this first step. In said first step polySi is deposited

means of a gaseous mixture of SiH₄+H₂+PH₃, using a deposition machine type LPCVD (Low Pressure Chemical Vapour Deposition). Deposition temperature is about 650 °C. Deposition time is set to obtain an intermediate layer L1 about 120 nanometers thick.

Fig. 2b shows a second purge step of the deposition process according to this invention for *in-situ* deposition and doping of a polySi layer. The gaseous mixture flow of SiH₄+H₂+PH₃ inside the deposition chamber is interrupted during this purge step. The purpose of said purge step is to remove all available dopant to avoid contamination during deposition of a subsequent additional layer L2. This occurs since during the deposition process the gaseous mixture is flowed through the deposition chamber through inlet and outlet pumps When stopping the gas flow, the residual gas is pumped out of the deposition chamber

Fig. 2c shows a third step of a non doped polySi deposition. Non doped polySi also means a polySi with a doping atoms concentration considerably lower compared to a polySi layer defined as a doped polySi. A gaseous mixture of SiH₄+H₂ is used. Deposition time is set to obtain a second additional non doped polySi layer L2 about 15 nanometer thick Determination of this thickness is based on the need that the average doping level resulting from the summation between the first intermediate polySi layer L1 and the second additional polySi layer L2 should not significantly change when redistribution of doping atoms will take place - as better explained in the following. To this purpose, a 10:1 ratio is maintained between the thickness of the first intermediate doped polySi layer L1 and the thickness of the second additional non doped polySi layer L2

Fig. 2d shows a fourth reoxidation step, during which the dopant contained in the first intermediate doped polySi layer L1 is diffused into the second additional layer of non doped polySi L2 due to thermal diffusion. As a result, doping levels of the first intermediate polySi layer L1 and second additional polySi layer L2 appear substantially equal at the end of the fourth reoxidation step

The characteristics and benefits deriving from this invention are apparent and obvious from the above description

The deposition process according to this invention is conveniently divided in two parts a first stage identical to the stage of a conventional *in-situ* deposition process of doped polySi followed by a second stage where non doped polySi or anyway with a doping level significantly lower compared to the previous one is deposited This second layer performs as a barrier against the out-doping phenomenon during the reoxidation process, without any recourse to oxide barriers.

Moreover, since the use of oxide is not required, also the crystallographic defectivity induced by the process will be reduced, since the first stage of the subsequent reoxidation process may not be an oxidating process and allow annealing of the defects generated during the previous implantation stages.

Moreover, it is also beneficial to have no recourse to oxidation for a better adhesion of silicide on polySi pertaining to the second layer.

Finally, removal of the deposited polySi from the wafer slice backside is conveniently avoided. Also, as regards control of the total layer thickness it is simply necessary to take into account the sum of the thicknesses of the two polySi layers deposited.

It is obvious that many changes are possible for the man skilled in the art to the *in-situ* deposition and doping process of one or more layers of polycrystalline silicon described by way of example, without departing from the principles of the innovative idea, and it is also clear that in practical actuation the shape and size of the components described above may be different and replaced with other technically equivalent elements

When deposition takes place, the second additional polySi layer can be substantially free from doping atoms or have a dopant concentration substantially lower (eg 10¹⁷ atoms/cm⁻³) compared to the first intermediate layer.

Moreover, deposition of the layers can take place using all techniques apt to produce a polySi with electronic properties suitable for integrated circuits and *in situ* doping, including for instance all vapour-phase deposition techniques.

As a matter of fact, the above description concerns a process tending to obtain a Flash memory process, wherein two polySi layers with different functions are available. However, this innovative technique can also be used in single polySi layer devices, such as CMOS logics, Power Discrete Circuits (VDMOSFETs, IGBTs..) and Power ICs

The process according to this invention is also applicable to all semiconductor devices requiring a heavy type n⁻ doping of polySi layers while avoiding at the same time the problems related to the use of the *in-situ* technique. However, the procedure is applicable also for deposition of polycrystalline silicon layers type p

## Claims

1. An *in-situ* deposition and doping process of one or more layers of polycrystalline silicon, specifically at high doping level, for electronic semiconductor devices, wherein said process provides at least a first growth step of a first intermediate layer (L1) of *in-situ* doped polycrystalline silicon with a determined doping level and a second growth step of a second additional layer (L2) of polycrystalline silicon with a lower doping level compared to the first intermediate layer (L1) of polycrystalline silicon, **characterized in that** an intermediate purge step is provided between the first growth step of the first intermediate layer (L1) of the *in-situ* doped polycrystalline silicon and the second growth step of the second additional layer (L2) of polycrystalline silicon, and **in that** the first growth step of the *in-situ* doped polycrystalline silicon produces a layer of polycrystalline silicon (L1) whose thickness is maintained at a 10:1 ratio with the thickness of the polycrystalline silicon layer (L2) obtained by the second growth step of polycrystalline silicon.

## Patentansprüche

1. In-situ-Abscheidungs- und Dotierungsprozess von einer oder mehr Schichten aus polykristallinem Silizium, speziell bei hohem Dotierungsniveau, für elektronische Halbleiter-Einrichtungen, wobei der Prozess aufweist
zumindest einen ersten Aufwachs-Schritt einer ersten Zwischenschicht (L1) aus *in-situ* dotiertem polykristallinen Silizium mit einem bestimmten Dotierungsniveau und
einen zweiten Aufwachs-Schritt einer zusätzlichen zweiten Schicht (L2) aus polykristallinem Silizium mit einem im Vergleich zu der ersten Zwischenschicht (L1) aus polykristallinem Silizium niedrigeren Dotierungsniveau,
**dadurch gekennzeichnet,**
**dass** ein Reinigungs-Zwischenschritt vorgesehen wird zwischen dem ersten Aufwachs-Schritt der ersten Zwischenschicht (L1) aus *in-situ* dotiertem polykristallinen Silizium und dem zweiten Aufwachs-Schritt der zusätzlichen zweiten Schicht (L2) aus polykristallinem Silizium, und
**dass** der erste Aufwachs-Schritt des *in-situ* dotierten polykristallinen Siliziums eine Schicht (L1) aus polykristallinem Silizium erzeugt, deren Dicke in einem Verhältnis von 10:1 zu der Dicke der polykristallinen Schicht (L2), die durch den zweiten Aufwachs-Schritt aus polykristallinem Silizium erhalten wird, gehalten wird.

## Revendications

1. Procédé de déposition et de dopage *in situ* d'une ou plusieurs couches de polycrystalline silicium, en particulier à un taux de dopage élevé, pour des dispositifs semi-conducteurs électroniques, où ledit procédé offre au moins une première étape de croissance d'une première couche intermédiaire (L1) de polycrystalline silicium dopé *in situ* avec un taux de dopage déterminé et une deuxième étape de croissance d'une deuxième couche additionnelle (L2) de polycrystalline silicium, ayant un taux de dopage inférieure à celui de la première couche intermédiaire (L1) de polycrystalline silicium, **caractérisé en ce qu'**une étape de purgeage intermédiaire est proposée entre la première étape de croissance de la première couche intermédiaire (L1) de polycrystalline silicium dopé *in situ* et la deuxième étape de croissance de la deuxième couche additionnelle (L2) de polycrystalline silicium, et **en ce que** la première étape de croissance du polycrystalline silicium dopé *in situ* produise une couche de polycrystalline silicium (L1) dont l'épaisseur est maintenue à un rapport 10:1 par rapport à l'épaisseur de la couche de polycrystalline silicium (L2) obtenue par la deuxième étape de croissance du polycrystalline silicium.
